# EUROPEAN PATENT SPECIFICATION

(11) **EP 1 628 331 B1**
(45) Date of publication and mention of the grant of the patent: **15.12.2010**
(21) Application number: 05254890.6
(22) Date of filing: 05.08.2005
(51) Int. Cl.: H01L 21/20, H01L 23/15, C23C 14/34, H01L 21/00, H01C 7/00, H01C 17/12, H01C 3/12, H05B 3/26

(54) **Electrical device having a heat generating electrically resistive element and heat dissipating means therefor**
Elektrische Vorrichtung mit einem wärmeerzeugenden elektrischen Widerstandselement und Wärmeableitungsmitteln dafür
Dispositif électrique ayant un élément résistif pour la génération électrique de chaleur et moyens de dissipation de chaleur

(30) Priority: 16.08.2004 GB 0418218
(43) Date of publication of application: 22.02.2006
(73) Proprietor: TYCO ELECTRONICS (UK) LTD, Swindon, Wiltshire SN3 5HH (GB)
(72) Inventor: Catchpole, Jonathan, Oxfordshire, OX14 3XH (GB); Lee, James Robert, Bath, BA1 5NN (GB); Melbourne, Christopher Robert, Bath, BA1 5TU (GB); Smart, Kenneth Charles Etherington, County Durham, DH9 9RL (GB)
(74) Representative: Shelley, Mark Raymond

(56) References cited:
- WO-A-2004/003943
- GB-A- 2 360 530
- US-A- 4 498 071
- US-A1- 2001 036 506

## Description

This invention relates to electrical devices such as power resistors and the like and, in particular, concerns improvements relating to the heat dissipating properties of such devices.

Electrical devices such as power resistors and the like generate significant heat during operation, and it is usual to provide such devices with a heat transfer medium for transferring heat from the device to a suitable heat sink, such as a metal plate or other body of heat conducting material.

A power resistor is described in U.S. Patent No. 5,355,281 in which a heat generating electrically conductive element is secured to one side of a bonded ceramic-copper laminate plate. The heat generating element is enclosed within a resistor housing by attachment of the heat conducting plate to an open end of the housing. The laminated plate comprises an intermediate layer of nickel-plated copper positioned between first and second alumina (aluminum oxide) ceramic layers. The heat generating element is secured to the alumina substrate on one side of the plate while the ceramic substrate on the other side of the plate is nickel-plated and is located on an exterior of the assembled device. Internally, the heat generating element is electrically connected to a terminal provided on the exterior of the housing. Typically in devices of this type, the interior of the housing is filled with a so-called "potting compound" of silicon resin insulating material, which is mixed under vacuum conditions to eliminate voids in the insulation so that partial discharge of the high voltage resistor element is minimized during operation.

The power resistor described above is typical of known types of power resistors where a heat generating resistive element is provided on an alumina (aluminum oxide), ceramic substrate. The thermally conductive substrate constitutes part of the heat transfer medium of the resistor. The thermal conductivity of the substrate determines the maximum rate of heat transfer from the resistive element to the heat sink normally attached to the resistor in use. Aluminum oxide has a thermal conductivity of approximately 30 W/m°K and while this is adequate for many applications, it is often necessary to use multiple power resistors to match the power dissipating requirements of specific applications, for example, in snubber applications and the like.

WO2004/003943 (D1) describes a sensor or heating element comprising an aluminium nitride substrate having a metalised tungsten layer of between 0.1 and 1 micrometre thickness applied to the surface thereof. The tungsten layer can be applied with the correct stoichiometry to the aluminium nitride surface by several vapour-phase deposition techniques, such as radio frequency/direct current sputtering, radio frequency/direct current co-sputtering, E-beam evaporation and chemical-vapour deposition (CVD). The thickness of the aluminium nitride substrate is preferably in the range 25 to 36 micrometres. The tungsten layer is arranged in a convoluted serpentine arrangement on the substrate with the ends of the serpentine running into rectangular shaped electrodes.

US2001/0036506 (D2) discloses a metalised substrate for a semi-conductor circuit. An aluminium nitride substrate comprises a "via" hole and is coated on both sides with thin metal films at least two of which are connected electrically by a thin resistance layer applied to the substrate in the region between the metal films. The holes are filled with an electrically conducting layer, such as tungsten or molybdenum, so that metal films on both sides of the substrate are electrically connected. The resistance layer may be formed from Ni/Cr having a thickness in the range of 0.01 to 0.5 micrometres which may be applied to the substrate by means of a reactive sputtering method.

There is a need therefore to improve the thermal conductivity of the substrate on which the heat generating element is provided in an electrical device such as a power resistor. In particular, there is a need to improve construction of power resistors and the materials used in such devices.

According to the invention, there is provided a power resistor as claimed in Claim 1.

The thermal conductivity of aluminum nitride is approximately 165 w/m°K and therefore has at least five times the thermal conductivity of aluminum oxide. Aluminum nitride also has similar dielectric properties to aluminum oxide and is therefore a suitable substrate material for use in electrical devices having heat generating electrically resistive elements. Vapor deposition of the resistive element material onto the surface of the aluminum nitride substrate provides good adhesion of the resistive element to the substrate such that de-lamination of the resistive element and the substrate during the service life of the device is minimized.

The high quality of adhesion that is achieved between the vapor deposition element and the substrate also leads to improvements in the transfer of heat from the resistive element to the substrate in use.

In preferred embodiments, the resistive element is deposited on the aluminum nitride substrate by a physical vapor deposition process, preferably by sputtering and most preferably by reactive sputtering, for example, using a nitrogen or oxygen reactive gas in combination with an inert process gas, typically argon. Reactive sputtering readily enables the chemical composition of the vapor deposition material of the resistive element to be altered by adjusting the concentration of reactive gas introduced in the deposition chamber during the sputtering process. This readily enables the resistance of the resistive element to be controlled during manufacture according to the relative concentration of the reactive gas during sputtering.

Preferably, the resistive element comprises a film of electrically resistive material deposited on the substrate. The thickness of the film may be in the range 0.5-25 microns, preferably 8-20 microns. At film thicknesses less than 8 microns, the capacity of the resistive element to absorb short bursts of pulse energy, for example, pulses of the order 460J in 10.5ms, can be limited. With film thickness less than 8 microns, there is also a risk that holes or indentations in the substrate material, typically up to 6 microns in depth, are not adequately covered by the deposited material leading to spark erosion of the non-coated or partially coated substrate material in the region of the surface indentations when subject to high voltages during operation of the electrical device.

Preferably, the resistive element comprises a film of metallic material deposited on the substrate. In one embodiment, high purity 80/20 nickel/chromium metal alloy is used.

Preferably, at least the edges of the resistive element are coated with an electrically insulating film, which extends over the adjacent substrate material at the edges of the resistive element. The insulating film may comprise a thick film silica over-glaze, for example, a low temperature glass encapsulant composition or similar material suitable for forming an insulating and protective (passivation) layer. Alternatively, the insulating film may comprise a thick film polymer encapsulant composition suitable for encapsulation applications on resistor networks and the like. In other embodiments, thin film dielectric materials, such as quartz or alumina may be used.

The insulating film may be applied over substantially the whole area of the resistive element with contact areas being provided at a film-free region or regions that are surrounded by the insulating film so that electrical connection to the resistive element may be made at the film-free region or regions of the contact or contacts. The insulating film protects the resistive film from oxidation and improves the stability of the electrical device.

Preferably, the electrical device according to the above aspect of the invention comprises a power resistor having a power rating of at least one Watt.

According to the invention, there is further provided a method as claimed in Claim 14.

The above method readily enables electrical devices having a power dissipating electrically resistive element to be manufactured with a wide range of resistances and a high degree of repeatability in a mass production environment with acceptable manufacturing and performance tolerances and no 'target poisoning' (reaction between target and reactive gas). Repeatability and economically acceptable rates of depositing the resistive material can be readily achieved by controlling the introduction of the reactive gas in the deposition chamber in the region of the substrate. Preferably, the high density plasma is generated by a helical radio frequency (RF) antenna disposed around a plasma generating tube remote from the deposition chamber.

Preferably, the plasma is generated as a high density plasma and, in preferred embodiments, is generated remote from the surface of the target and the substrate to be coated.

Preferably, the method further comprises the step of masking the surface of the substrate to be coated so that only the unmasked parts of the substrate are coated during vapor deposition.

Preferably, the method further comprises the step of cleaning the surface of the substrate to be coated prior to vapor deposition. The surface may be first cleaned using a solvent. The surface of the substrate may be cleaned by a radio frequency cleaning process. Preferably, the surface of the substrate is cleaned by plasma washing and additionally or alternatively by plasma etching.

Preferably, the step of cleaning the surface of the substrate is carried out in the deposition chamber by directing the plasma towards the substrate and not the target.

An embodiment of the present invention will now be more particularly described, by way of example only, with reference to the accompanying drawings, in which:
Figure 1 is an exploded cross-sectional view of a power resistor according to an embodiment of the present invention;
Figure 2 is a plan view of a substrate of the power resistor of Figure 1 as viewed in the direction II;
Figure 3 is a plan view of the ceramic substrate of Figure 2 showing parallel strips of resistive material applied to a surface of the substrate;
Figure 4 is a plan view of the ceramic substrate of Figure 3 having metallic thin-film connecting strips applied over the respective adjoining ends of the parallel strips of resistive material on the surface of the substrate.

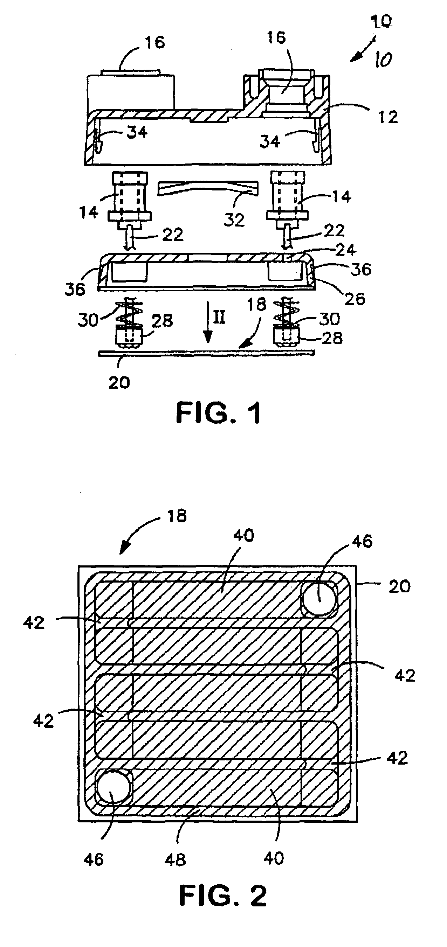

Referring to Figure 1, an electrical device 10 comprises a power resistor, that is to say a resistor having a power rating of one Watt or more. The device 10 includes an injection-molded outer casing 12 having a pair of electrical terminals 14 which extend through respective through-holes 16 in the outer casing 12. Embodiments are also envisioned where four or more of the terminals 14 are provided. The terminals 14 are electrically connected to a resistor comprising a resistive element 18 (see Figure 2) provided on a thermally conductive dielectric ceramic substrate 20. In embodiments of the present invention, the ceramic substrate 20 is an aluminum nitride substrate. The terminals 14 are connected to the resistive element 18 via respective wires 22. The wires 22 pass through apertures 24 in inner casing 26 and terminate at respective three point electrical contacts 28. The contacts 28 are biased against contact surfaces on the resistive element 18 by respective compression springs 30. In use, the ceramic substrate 20 is held against a surface of an adjoining heat sink (not shown) by a compressive clamping force of a predetermined strength provided by a disk-shaped resilient spring element 32. The clamping force is provided by tightening fastening screws on the device 10. The device 10 is clamped to the heat sink with a thermal grease applied there between. The clamping force is applied centrally and is of a pre-determined magnitude to ensure optimum heat transfer. The inner casing 26 is bonded to the ceramic substrate 20, preferably by a silicon-based adhesive. The inner casing 26 sits on the ceramic substrate 20 so that the interior of the inner casing 26 is closed by the substrate 20. An interior of the inner casing 26 is "potted" with a silicon resin insulating material in a manner which is well known to those skilled in the art.

The ceramic substrate 20 provides a heat transfer medium for transferring heat generated by the resistive element 18 in use.

The disc-shaped resilient spring element 32 is provided between the inner and outer casings 26, 12 to bias the inner and outer casings 26, 12 apart. Resilient hooks 34 in an interior of the outer casing 12 engage corresponding indentations 36 on an outer surface of the inner casing 26 when the component parts shown in the exploded view of Figure 1 are assembled together.

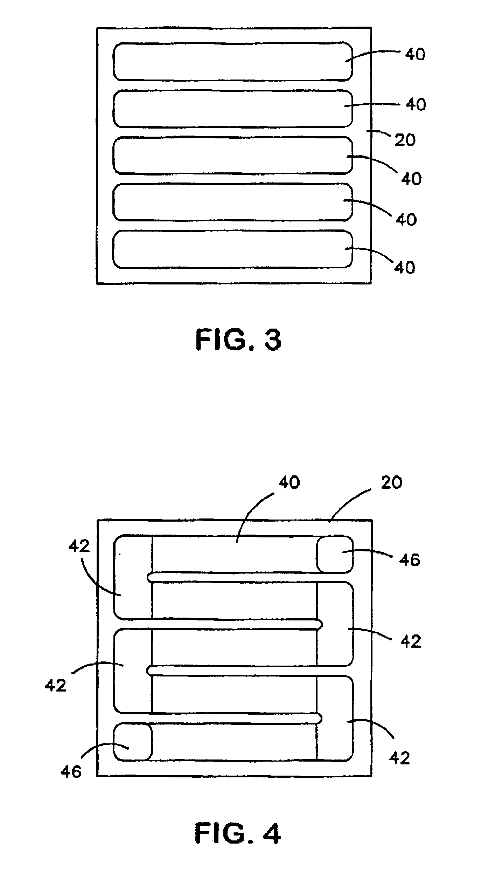

Figure 2 shows the resistive element 18 in plan view on the substrate 20. The detailed construction of the resistive element 18 is best explained with reference to the drawings of Figures 3 and 4 which show sequentially the manufacturing steps of the resistive element 18 on the aluminum nitride substrate 20. In Figure 3, a plurality of parallel strips 40 of 80/20 nickel/chromium material are provided on the substrate 20 by vapor deposition. In this process, the aluminum nitride substrate 20 is first subject to a cleaning step which preferably comprises plasma etching the surface of the aluminum nitride substrate 20 that is to be coated with the resistive material. Once the substrate 20 has been cleaned, a mask is applied to the surface of the substrate 20 to cover the whole of the substrate 20 except for the parallel strips 40 where the resistive material is to be deposited. The resistive material is deposited by means of a physical vapor deposition process. In this process, a high density plasma is generated remote from the surface of the target nickel/chromium material and the aluminum nitride substrate 20 that is to be coated. The nickel chromium material is deposited on the substrate 20 to form the parallel strips 40 by introducing at least part of a process gas, for example argon, in a region of the target in the vapor deposition chamber and introducing a controlled amount of reactive gas, for example oxygen or nitrogen, in a region of the substrate 20. This process is preferably carried out in a sputtering system of the type described in UK Patent Application No. 2,360,530, which describes the process of generating a high density plasma using a helical radio frequency antenna disposed around a plasma generating tube that is connected to, but remote from, the main deposition chamber. This process enables nickel chromium films of between 0.5 to 25 microns thickness to be deposited on the substrate 20 as parallel strips 40. By controlling the amount of reactive gas, the chemical composition of the sputtered material on the substrate 20 can be altered so that the resistivity of the parallel strips 40 can be controlled during manufacture enabling high levels of repeatability to be achieved in a mass production environment.

Referring now to Figure 4, once the parallel strips 40 of resistive material have been deposited on the substrate 20, connecting strips 42 of a thin-film metal, for example copper, are deposited over the respective ends of the parallel strips 40 to create a continuous strip of electrically conductive material on the substrate 20 in the shape of a serpentine. The connecting strips 42 bridge a gap between ends of adjoining parallel strips 40 to form a U-shaped bend at the ends of pairs of adjacent parallel strips 40 to provide the resistive element 18 with the serpentine shape. The connecting strips 42 prevent so-called "current crowding" at inside corners of the connecting strips 42, which would otherwise occur if the connecting strips 42 were to comprise an electrically resistive material. If a conductive material was not used for strips 42, this would result in burning at the inside corners due to the concentration of current.

The connecting strips 42 preferably have a thickness of 4 microns. In addition to the connecting strips 42, a thin film of copper, also 4 microns, is applied at terminal ends 46 of the serpentine for contact with the three point contacts 28 of the power resistor. Once the copper film has been applied to the resistive element 18, a thin-film, for example 300 Angstroms of 80/20 nickel/chromium, is applied over the whole surface of the connecting strips 42 and the copper contacts at the terminal ends 46. This final nickel chromium film is also applied by sputtering. Finally, as shown in Figure 2, an insulating film 48, indicated by the region of hatched lines, is applied to the surface of the substrate 20 covering the whole of the resistive element 18 apart from the terminal ends 46. The insulating film 48 provides a partial discharge seal on the surface of the substrate 20 on which the resistive element 18 is applied. A reverse side of the substrate 20 also comprises a partial discharge layer which is formed by providing an electrically conductive thick or thin film coating over the whole of the reverse surface of the substrate 20. This layer enables the substrate 20 to be mounted on an adjoining surface at the same potential to avoid the formation of any voids between the substrate 20 and the adjoining surface.

Although aspects of the invention have been described with reference to the embodiments shown in the accompanying drawings, it is to be understood that the invention is not limited to these precise embodiments and that various changes and modifications may be effected within the scope of the appended claims without further inventive skill and effort. For example, the invention also contemplates embodiments in which the connecting wires 22 are soldered directly to the terminal ends 46, or the resistive element 18 is provided on a cylindrical (tubular or solid, or arcuate-shaped diametric aluminum nitride substrate). The invention also contemplates resistive elements 18 comprising a plurality of parallel strips on an aluminum nitride substrate, such as the parallel strips 40, which are joined electrically in parallel at their respective ends, rather than in series, as in the embodiment described with reference to Figures 1 to 4.

## Claims

1. A power resistor (10) comprising a power dissipating electrically resistive element (18) vapor deposited on an aluminum nitride substrate, wherein the resistive element comprises a film of electrically resistive material deposited on the substrate and the thickness of the film is in the range 8 to 25 microns.

2. A power resistor as claimed in Claim 1 wherein the resistive element is deposited on the substrate by physical vapor deposition.

3. A power resistor as claimed in Claim 2 wherein the resistive element is deposited on the substrate by sputtering.

4. A power resistor as claimed in Claim 3 wherein the resistive element is deposited by reactive sputtering.

5. A power resistor as claimed in Claim 4 wherein the resistive element is deposited by reactive sputtering and doped using a nitrogen or oxygen reactive gas.

6. A power resistor as claimed in Claim 1 wherein the thickness of the film is in the range 0.5 to 25 microns.

7. A power resistor as claimed in any preceding claim wherein the resistive element comprises a film of metallic material deposited on the substrate.

8. A power resistor as claimed in Claim 7 wherein the metallic material comprises a nickel/chromium alloy.

9. A power resistor as claimed in any preceding claim wherein at least the edges of the resistive element are coated with an electrically insulating film which extends over the adjacent substrate material at the edges of the resistive element.

10. A power resistor as claimed in Claim 9 wherein the whole of resistive element is coated with an insulating film with non-coated regions on the resistive element for electrical contact thereto.

11. A power resistor as claimed in any preceding claim wherein the resistor has a power rating of at least 1 Watt.

12. A power resistor as claimed in any preceding claim wherein the resistive element comprises a plurality of substantially parallel strips of resistive material vapour deposited on said substrate, connecting strips of a thin film metal deposited over the respective ends of the parallel strips, the connecting strips bridging a gap between ends of adjoining parallel strips to form a U-shaped bend at the ends of pairs of adjacent parallel strips to provide a resistive element with a serpentine shape.

13. A power resistor as claimed in Claim 12 wherein the connecting strips comprise strips of copper deposited on the substrate between the respective ends of the said adjacent strips of resistive material.

14. A method to manufacture a power resistor (10) having a power dissipating electrically resistive element (18) according to any preceding claim wherein the electrically resistive element is deposited on the aluminum nitride substrate by the steps of generating a plasma, introducing at least part of a process gas in a region of a target and introducing a reactive gas in a region of the substrate.

15. A method as claimed in Claim 14 wherein the plasma is generated by a helical radio frequency antenna disposed around a plasma source generating tube.

16. A method as claimed in Claim 14 or Claim 15 wherein the surface of the substrate to be coated is cleaned by plasma cleaning prior to vapor deposition.

17. A method as claimed in any one of Claims 14 to 16 wherein the surface of the substrate is masked prior to applying the metallic layer to the unmasked parts of the substrate by vapor deposition.

18. A method as claimed in any of Claims 14 to 17 wherein the plasma is a high density plasma.

19. A method as claimed in any of Claims 14 to 18 wherein the plasma is generated as a high density plasma remote from the surface of the target and the aluminum nitride substrate to be coated.

## Patentansprüche

1. Hochleistungswiderstand (10), der ein leistungsverbrauchendes elektrisches Widerstandselement (18) aufweist, das auf ein Aluminiumnitridträgermaterial aufgedampft ist, wobei das Widerstandselement eine Schicht des elektrischen Widerstandsmaterials aufweist, das auf dem Trägermaterial abgeschieden ist, und wobei die Dicke der Schicht im Bereich von 8 bis 25 µm liegt.

2. Hochleistungswiderstand nach Anspruch 1, bei dem das Widerstandselement auf dem Trägermaterial durch physikalische Aufdampfung abgeschieden wird.

3. Hochleistungswiderstand nach Anspruch 2, bei dem das Widerstandselement auf dem Trägermaterial durch Zerstäubung abgeschieden wird.

4. Hochleistungswiderstand nach Anspruch 3, bei dem das Widerstandselement durch reaktionsfähige Zerstäubung abgeschieden wird.

5. Hochleistungswiderstand nach Anspruch 4, bei dem das Widerstandselement durch reaktionsfähige Zerstäubung abgeschieden und bei Verwendung eines Stickstoff- oder Sauerstoffreaktionsgases dotiert wird.

6. Hochleistungswiderstand nach Anspruch 1, bei dem die Dicke der Schicht im Bereich von 0,5 bis 25 µm liegt.

7. Hochleistungswiderstand nach einem der vorhergehenden Ansprüche, bei dem das Widerstandselement eine Schicht aus metallischem Material aufweist, die auf dem Trägermaterial abgeschieden wird.

8. Hochleistungswiderstand nach Anspruch 7, bei dem das metallische Material eine Nickel/Chrom-Legierung aufweist.

9. Hochleistungswiderstand nach einem der vorhergehenden Ansprüche, bei dem mindestens die Ränder des Widerstandselementes mit einer elektrisch isolierenden Schicht beschichtet sind, die sich über das benachbarte Trägermaterial an den Rändern des Widerstandselementes erstreckt.

10. Hochleistungswiderstand nach Anspruch 9, bei dem das gesamte Widerstandselement mit einer isolierenden Schicht beschichtet ist, wobei nichtbeschichtete Bereiche auf dem Widerstandselement für einen elektrischen Kontakt damit vorhanden sind.

11. Hochleistungswiderstand nach einem der vorhergehenden Ansprüche, bei dem der Widerstand eine Nennleistung von mindestens 1 Watt aufweist.

12. Hochleistungswiderstand nach einem der vorhergehenden Ansprüche, bei dem das Widerstandselement aufweist: eine Vielzahl von im Wesentlichen parallelen Streifen des Widerstandsmaterials, die auf das Trägermaterial aufgedampft wurden; Verbindungsstreifen aus einer dünnen Metallschicht, die über den entsprechenden Enden der parallelen Streifen abgeschieden wurden, wobei die Verbindungsstreifen einen Spalt zwischen den Enden von angrenzenden parallelen Streifen überbrücken, um eine U-förmige Biegung an den Enden der Paare von benachbarten parallelen Streifen zu bilden, um ein Widerstandselement mit einer Schlangenlinienform zu liefern.

13. Hochleistungswiderstand nach Anspruch 12, bei dem die Verbindungsstreifen Kupferstreifen aufweisen, die auf dem Trägermaterial zwischen den jeweiligen Enden der benachbarten Streifen des Widerstandsmaterials abgeschieden wurden.

14. Verfahren zur Herstellung eines Hochleistungswiderstandes (10) mit einem leistungsverbrauchenden elektrischen Widerstandselement (18) nach einem der vorhergehenden Ansprüche, bei dem das elektrische Widerstandselement auf dem Aluminiumnitridträgermaterial mittels der folgenden Schritte abgeschieden wird: Erzeugen eines Plasmas; Einführen von mindestens einem Teil eines Prozessgases in einen Zielbereich; und Einführen eines Reaktionsgases in einen Bereich des Trägermaterials.

15. Verfahren nach Anspruch 14, bei dem das Plasma mittels einer wendelförmigen Hochfrequenzantenne erzeugt wird, die um ein Plasmaerzeugungsrohr angeordnet ist.

16. Verfahren nach Anspruch 14 oder Anspruch 15, bei dem die Oberfläche des zu beschichtenden Trägermaterials mittels Plasmareinigung vor der Aufdampfung gereinigt wird.

17. Verfahren nach einem der Ansprüche 14 bis 16, bei dem die Oberfläche des Trägermaterials vor der Aufbringung der Metallschicht auf die nicht abgedeckten Teile des Trägermaterials durch Aufdampfung abgedeckt wird.

18. Verfahren nach einem der Ansprüche 14 bis 17, bei dem das Plasma ein Plasma hoher Dichte ist.

19. Verfahren nach einem der Ansprüche 14 bis 18, bei dem das Plasma als ein Plasma hoher Dichte entfernt von der Zielfläche und dem zu beschichtenden Aluminiumnitridträgermaterial erzeugt wird.

## Revendications

1. Résistance de puissance (10), comprenant un élément à résistance électrique à dissipation de la puissance (18), déposé en phase vapeur sur un substrat de nitrure d'aluminium, l'élément résistance comprenant un film de matériau à résistance électrique déposé sur le substrat, l'épaisseur de film étant comprise dans l'intervalle allant de 8 à 25 microns.

2. Résistance de puissance selon la revendication 1, dans laquelle l'élément résistant est déposé sur le substrat par dépôt physique en phase vapeur.

3. Résistance de puissance selon la revendication 2, dans laquelle l'élément résistant est déposé sur le substrat par pulvérisation cathodique.

4. Résistance de puissance selon la revendication 3, dans laquelle l'élément résistant est déposé par pulvérisation cathodique réactive.

5. Résistance de puissance selon la revendication 4, dans laquelle l'élément résistant est déposé par pulvérisation cathodique réactive et est dopé par l'intermédiaire d'un gaz d'azote ou d'oxygène réactif.

6. Résistance de puissance selon la revendication 1, dans laquelle l'épaisseur du film est comprise dans l'intervalle allant de 0,5 à 25 microns.

7. Résistance de puissance selon l'une quelconque des revendications précédentes, dans laquelle l'élément résistant comprend un film de matériau métallique déposé sur le substrat.

8. Résistance de puissance selon la revendication 7, dans laquelle le matériau métallique comprend un alliage de nickel/chrome.

9. Résistance de puissance selon l'une quelconque des revendications précédentes, dans laquelle au moins les bords de l'élément résistant sont revêtus d'un film à isolation électrique, s'étendant au-dessus du matériau du substrat adjacent au niveau des bords de l'élément résistant.

10. Résistance de puissance selon la revendication 9, dans laquelle l'ensemble de l'élément résistant est revêtu d'un film isolant, avec des régions non revêtues sur l'élément résistant, pour assurer un contact électrique avec celui-ci.

11. Résistance de puissance selon l'une quelconque des revendications précédentes, dans laquelle la résistance présente une puissance nominale d'au moins 1 Watt.

12. Résistance de puissance selon l'une quelconque des revendications précédentes, dans laquelle l'élément résistant comprend plusieurs bandes pratiquement parallèles de matériau résistant, déposées en phase vapeur sur ledit substrat, des bandes de connexion d'un métal à couche mince déposées au-dessus des extrémités respectives des bandes parallèles, les bandes de connexion enjambant un espace entre les extrémités de bandes parallèles adjacentes pour former un coude en U au niveau des extrémités de paires de bandes parallèles adjacentes, afin de produire un élément résistant ayant une forme en serpentin.

13. Résistance de puissance selon la revendication 12, dans laquelle les bandes de connexion comprennent des bandes de cuivre déposées sur le substrat entre les extrémités respectives desdites bandes adjacentes de matériau résistant.

14. Procédé de fabrication d'une résistance de puissance (10) comportant un élément à résistance électrique à dissipation de la puissance (18) selon l'une quelconque des revendications précédentes, l'élément à résistance électrique étant déposé sur le substrat de nitrure d'aluminium par les étapes de production d'un plasma, d'introduction d'au moins une partie d'un gaz de procédé dans une région d'une cible et d'introduction d'un gaz réactif dans une région du substrat.

15. Procédé selon la revendication 14, dans lequel le plasma est produit par une antenne hélicoïdale haute fréquence agencée autour d'un tube générateur d'une source de plasma.

16. Procédé selon les revendications 14 ou 15, dans lequel la surface du substrat devant être revêtue est nettoyée par nettoyage au plasma avant le dépôt en phase vapeur.

17. Procédé selon l'une quelconque des revendications 14 à 16, dans lequel la surface du substrat est masquée avant l'application de la couche métallique sur les parties non masquées du substrat par dépôt en phase vapeur.

18. Procédé selon l'une quelconque des revendications 14 à 17, dans lequel le plasma est un plasma haute densité.

19. Procédé selon l'une quelconque des revendications 14 à 18, dans lequel le plasma est produit sous forme d'un plasma haute densité à distance de la surface de la cible et du substrat de nitrure d'aluminium devant être revêtus.
